# EUROPEAN PATENT APPLICATION

(11) **EP 2 842 735 A1**
(43) Date of publication of application: **04.03.2015**
(21) Application number: 14183383.0
(22) Date of filing: 03.09.2014
(51) Int. Cl.: B32B 7/06, B32B 7/12, B32B 27/00, B32B 27/20, B32B 27/38

(54) **Pre-applied underfill**

(30) Priority: 03.09.2013 US 201314017264
(71) Applicant: Rohm and Haas Electronic Materials LLC, Marlborough, MA 01752 (US)
(72) Inventor: Gallagher, Michael K., Hopkinton, MA Massachusetts (US); Anzures, Edgardo, Westborough, MA Massachusetts 01581 (US); Fleming, David, Northborough, MA Massachusetts 01532 (US); Dhoble, Avin V., Waltham, MA Massachusetts 02453 (US); Truong, Chi Q., Westborough, MA Massachusetts 01581 (US); Choubey, Anupam, Watertown, MA Massachusetts 02472 (US); Calvert, Jeffrey M., Acton, MA Massachusetts 01720 (US)
(74) Representative: Houghton, Mark Phillip

(57) **Abstract**

Underfill structures useful as pre-applied underfill materials comprise a polymer layer having a first polymer region and a second polymer region, wherein the second polymer region comprises inorganic filler. Electronic assemblies comprising a chip or die and a substrate are formed using such multi-layer structured pre-applied underfill.

## Description

This invention relates generally to the field of electronics packaging, and more particularly to the field of pre-applied underfill.

Flip chip technology, wherein the integrated circuit (IC) chips are essentially flipped over and bonded to substrates using solderable interconnects, has seen rapid growth in semiconductor packaging in recent years. The key drivers for the demand for this technology are increased I/O connections enabling greater speed and shorter connections resulting in improved signal integrity. Underfill material, which occupies the space between the flipped IC chip and the substrate, is key for reliability of the flip chip packages. Underfill material supports the electrical connections, protects them from the environment, and reduces the thermomechanical stress on the flip chip connection. Generally, underfill materials, which are polymer-based, have different coefficients of thermal expansion (CTE) from the chip and substrate components, such as the solder connections. This CTE mismatch can lead to thermomechanical stresses that can cause device failure, such as when the device is subjected to temperature cycles. In order to reduce this CTE mismatch, underfill materials typically contain an inorganic filler, such as silica.

Dispensing the underfill at the edge of the chip on the substrate and allowing it to flow in the gap between the chip and substrate under capillary action has been the most common method of incorporating underfills in the packages. In certain scenarios, the capillary flow can be slow, such as when high levels of filler are added to the underfill material, and/or incomplete resulting in voids in the package and also possible non-homogeneity in the underfill between polymer and filler, due to settling of the filler during the capillary flow. This problem can be even more serious with increasing chip size and/or decrease in pitch size of the interconnect structures on a flip chip die.

An alternative underfill process is the no-flow underfill (NUF) process, where the underfill is dispensed onto the substrate and then the chip/die is placed on top of the underfill. However, this process still suffers from certain problems, such as the entrapment of filler particles between solderable features, such as solder bumps, on the chip/die and bonding pads on the substrate resulting in interconnect failures.

The WLUF (wafer level underfill) process is yet a further alternative where the underfill can be applied either on a bumped wafer, or on a wafer that does not have solder bumps and that subsequently undergoes a bumping process. The underfill material can be applied to the wafer by a variety of techniques, such as film lamination, spin coating or screen printing process. Similar to the NUF process, the WLUF process faces the challenge of avoiding filler entrapment between the solderable features on the wafer and the bonding pads on the substrate

U.S. Pat. No. 6,861,285 describes a process where a plurality of underfill layers is applied to a bumped wafer, with at least 1 underfill layer containing a filler material and at least one underfill layer that is free or substantially free of filler material, where each layer of underfill material is individually applied. The underfill layers containing filler are first applied on the wafer. After the desired number of such filled underfill layers are applied, then chemical and/or mechanical methods are used to remove the underfill material from the tops of the bumps and expose the top surface of the bumps. Such methods include polishing or grinding, dry or wet etching, chemical mechanical polishing, reactive ion etching, laser milling, and laser ablation. Next, the layer of underfill material that is free or substantially free of filler material is applied to the surface of the filled underfill layers and over the exposed top surface of the solder bumps. Finally, the wafer is joined to a substrate, where the solder bumps are brought into contact with corresponding bonding pads on the substrate. The process described in this patent requires a chemical and/or mechanical removal step during which the solder bumps can be easily damaged leading to a potentially high rate of device failures. There remains a need for an improved process for applying underfill material in making IC assemblies.

The present invention provides an underfill structure comprising in order: a top film layer; a polymer layer, and a bottom film layer, wherein the polymer layer comprises a first polymer region and a second polymer region, wherein the second polymer region comprises inorganic filler. Preferably, the first polymer region is free of inorganic filler. This multi-region underfill structure is applied to a substrate in a single step.

The present invention further provides a method comprising: providing the underfill structure described above; removing the bottom film from the underfill structure; laminating the underfill structure to a surface of a component having interconnect structures thereon, such that the underfill structure is forced between interconnect structures, wherein the height of the second polymer region is less than or equal to the height of the interconnect structures; and removing the top film layer. It is preferred that the height of the second polymer region is less than the height of the interconnect structures. In one embodiment, the height of the polymer layer is less than the height of the interconnect structures. Preferably, the present invention further comprises: registering a top portion of the interconnect structures with conductive bond pads on a surface of a substrate to form a unit; and electrically connecting the interconnect structures with the conductive bond pads. Heating, that is causing the interconnect structures to at least partially melt in order to join the interconnect structures with the bond pads, and thermosonic bonding are suitable methods of electrically connecting the interconnect structures and the conductive bond pads.

The present invention also provides a method comprising: providing the underfill structure described above; removing the bottom film from the underfill structure; laminating the underfill structure to a surface of a substrate having conductive bond pads such that the first polymer region is directly on the surface of the substrate; and removing the top film layer. Preferably, the present invention further comprises: registering the conductive bond pads with a top surface of interconnect structures on a surface of a component to form a unit; and electrically connecting the interconnect structures with the conductive bond pads. Heating, that is causing the interconnect structures to at least partially melt in order to join the interconnect structures with the bond pads, and thermosonic bonding are suitable methods of electrically connecting the interconnect structures and the conductive bond pads.
Figs. 1A and 1B are schematic drawings, in cross-section, of alternate embodiments of an underfill structure of the invention.
Fig. 2 is a schematic drawing showing a lamination process of disposing an underfill structure of the invention onto a wafer having solder bumps.
Figs. 3A and 3B are schematic drawings showing an alternate lamination process of disposing an underfill structure of the invention onto a wafer having metal pillar interconnect structures.
Fig. 4 is a schematic drawing illustrating an underfill structure of the invention laminated onto a substrate having metal pillar interconnect structures.
Figs. 5A - 5C are schematic drawings showing alternate lamination processes using an underfill structure of the invention and the resulting electronic assembly.
Fig. 6 is a cross-sectional micrograph of an underfill structure of the invention.

As used throughout this specification, the following abbreviations shall have the following meanings, unless the context clearly indicates otherwise: °C = degrees Celsius; g = gram; kg = kilograms; µm = microns = micrometers; mm = millimeters; min. = minutes; DI = deionized; mol = moles; and rpm = revolutions per minute. All amounts are percent by weight ("wt%") and all ratios are weight ratios, unless otherwise noted. All numerical ranges are inclusive and combinable in any order, except where it is clear that such numerical ranges are constrained to add up to 100%. In the figures, like reference numerals refer to like elements. The articles "a," "an" and "the" refer to the singular and the plural. "Alkyl" refers to linear, branched and cyclic alkyl. "Aryl" refers to aromatic carbocycles and aromatic heterocycles. The term "(meth)acrylate" includes both acrylates and methacrylates. Likewise, the term "(meth)acrylic" includes both acrylic and methacrylic.

It will be understood that when an element is referred to as being "on" another element, it can be directly on the other element or intervening elements may be present therebetween. In contrast, when an element is referred to as being "directly on" another element, there are no intervening elements present.

It will also be understood that, although the terms first, second, third, etc. may be used herein to describe various elements, components, regions, layers, portions or sections, these elements, components, regions, layers, portions or sections should not be limited by these terms. These terms are only used to distinguish one element, component, region, layer or section from another element, component, region, layer, portion or section. Thus, a first element, component, region, layer, portion or section could be termed a second element, component, region, layer or section without departing from the teachings of the present invention.

Furthermore, relative terms, such as "lower" or "bottom" and "upper" or "top," may be used herein to describe one element's relationship to another element as may be illustrated in the Figures. It will be understood that relative terms are intended to encompass different orientations of the device in addition to the orientation depicted in the Figures. For example, if the device in one of the Figures is turned over, elements described as being on the "lower" side of other elements would then be oriented on "upper" sides of the other elements. The exemplary term "lower," can therefore, encompasses both an orientation of "lower" and "upper," depending on the particular orientation of the Figure. Similarly, if the device in one of the Figures is turned over, elements described as "below" or "beneath" other elements would then be oriented "above" the other elements. The exemplary terms "below" or "beneath" can, therefore, encompass both an orientation of above and below.

The present invention provides a dry film structure useful to form a pre-applied underfill in electrical assemblies. The present structure comprises, in order: a top film layer; a polymer layer; and a bottom film layer; wherein the polymer layer comprises a first polymer region and a second polymer region, wherein the second polymer region comprises inorganic filler. Preferably, the first polymer region is free of inorganic filler. The structure may optionally comprise one or more layers of additional materials, such as buffer layers, release layers, and the like. Preferably, the structure comprises a buffer layer, and more preferably the buffer layer is disposed between the top film layer and the polymer layer. Optionally, the structure may include a release layer disposed between the bottom film layer and the polymer layer.

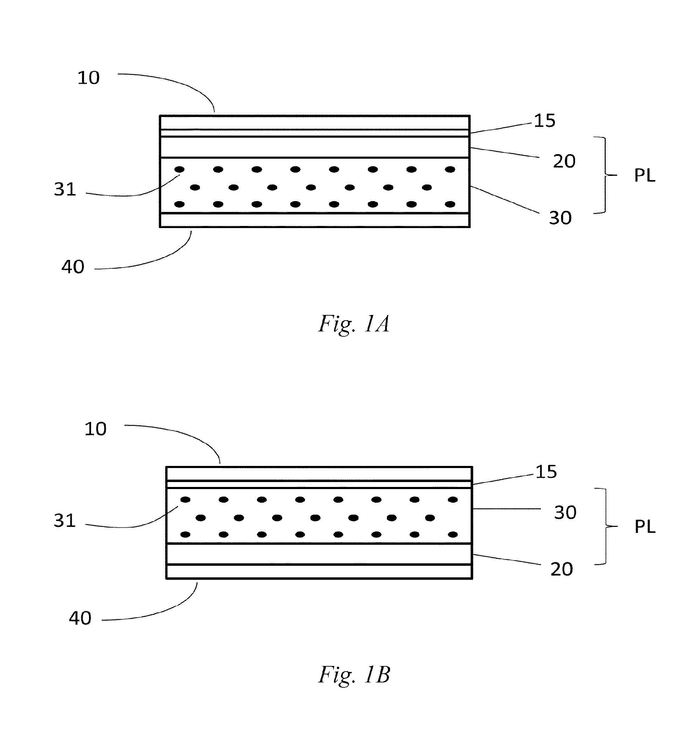

In one embodiment of the present structure, the top film layer is on the first polymer region of the polymer layer, and preferably a buffer layer is disposed between the top film layer and the first polymer region. Fig. 1A illustrates a cross-sectional schematic diagram of one embodiment of the invention having, in order, top film layer **10**, optional buffer layer **15**, polymer layer **PL** and bottom film **40**, where polymer layer **PL** is composed of first polymer region **20** on second polymer region **30**, the second polymer region **30** comprising inorganic filler **31**. In Fig. 1A, the top film layer **10** is on first polymer region **20** of the polymer layer, and second polymer region **30** of the polymer layer is directly on bottom film **40**. In an alternate embodiment, the top film layer is on the second polymer region, and preferably a buffer layer is disposed between the top film layer and the second polymer region. Fig. 1B illustrates a cross-sectional schematic diagram of this alternate embodiment of the invention having, in order, top film layer **10**, optional buffer layer **15**, polymer layer **PL** composed of second polymer region **30** comprising inorganic filler **31** on first polymer region **20**, where first polymer region **20** is on bottom film layer **40**. Either structure of Figs. 1A and 1B may optionally contain a release layer (not shown) disposed between polymer layer **PL** and bottom film layer **40**. In use, the bottom film is removed from the underfill structure before the structure is laminated to a surface, and, after lamination to a surface, the top film layer is then removed to provide the polymer layer on the surface as a pre-applied underfill.

The top film layer functions to protect the polymer layer during storage and handling, and to help position the polymer layer between interconnect structures during lamination. The top film layer has sufficient film integrity such that the top film layer is able to be removed from the polymer layer by peeling. Since the top film layer is removed from the underfill structure, such as by peeling, the adhesion between the top film layer and the polymer layer is typically low to moderate. A wide variety of polymers may be used as the top film layer, provided they meet the above criteria, including free-radical polymerization polymers, graft copolymers, step-growth polymerization polymers, and the like. Polymers useful as the top film layer include copolymers of: polyolefins; polyolefin copolymers; polyvinylchloride; polyvinylchloride copolymers; polydinylidenechloride; polyurethanes; polyurethane copolymers; poly(meth)acrylates; and poly(meth)acrylate copolymers. Preferred polyolefins include polyethylene, polypropylene, polybutylene, polyisobutylene, polybutadiene, and polyisoprene. Elastomers are another preferred class of polymeric materials useful as the top film layer. Such elastomers include, but are not limited to: polyolefin elastomers; ethylene vinyl acetate; polyether block amides; polyacrylic rubber, ethylene propylene rubber; ethylene propylene diene rubber; polyisobutylene polybutadiene; silicone-urethane copolymers; polybutadienepolyurethane copolymers; styrene-block copolymers; styrene-butadiene copolymers; and polyvinylchloride elastomers. Polyolefin eleastomers are well known in the art and are typically copolymers of ethylene and another alpha-olefin. In addition, it is preferred that the top film layer is sufficiently pliable to deform without deforming interconnect structures during lamination. The top film layer may have any suitable thickness, such as from 5 to 250 µm, and preferably from 10 to 150 µm.

Optionally, a buffer layer is disposed between the top film layer and the polymer layer. While not wishing to be bound by theory, the buffer layer acts as a buffer or cushion between the top film layer and interconnect structures during lamination, allowing for movement of the top film layer during lamination without deforming the interconnect structures. Any polymeric material that is sufficiently pliable to allow for movement of the top film layer during lamination or to deform during lamination without deforming interconnect structures may be used as the buffer layer. The buffer layer may also function to improve the adhesion between the top film layer and the polymer layer. It is preferred that the buffer layer is an adhesive material. A wide variety of adhesive materials known in the art may be used as the buffer layer, provided the adhesive material is peelable and not permanent. Preferably, the adhesive material is a pressure sensitive adhesive (PSA). Pressure sensitive adhesives are well-known in the art and typically comprise an elastomer, such as rubber, (meth)acrylates or silicones. When a buffer layer is used, it is preferred that the buffer layer remains with the top film layer when the top film layer is removed from the structure and that no buffer layer residue is left on the polymer layer. Any buffer layer residue remaining on the polymer layer after removal of the top film layer may be removed by contact with an appropriate remover, such as a suitable organic solvent. It is preferred that a buffer layer is disposed between the top film layer and the polymer layer, and more preferably that a PSA layer is disposed between the top film layer and the polymer layer. When used in the present invention, the thickness of the buffer layer is not critical, but is typically in the range of 5 to 100 µm, and preferably 10 to 50 µm. An advantage of the buffer layer is that it can also modify the adhesion energy between the top layer and the polymer layer.

In a preferred embodiment, a PSA tape is used in the present structure to form the top film layer and the buffer layer. A PSA tape is composed of a PSA layer disposed directly on a polymer film. The polymer film of the PSA tape functions as the top film layer in the present structure while the PSA layer functions as a buffer layer. A wide variety of PSA tapes are commercially available and may be used in the present invention. Particularly useful PSA tapes are backgrinding tapes. Exemplary PSA tapes are those sold under the trade names BG Tape (available from Lintec Corp.), BG-HTCR100-PET (available from AI Technology, Inc.), ICROS™ Tape (available from Mitsui Chemicals), ELEGRIP™ Tape (available from Denka), as well as other backgrinding tape available from Toyo Adtec, Furukawa Electric, and other commercial suppliers. Preferably, the tape has a UV light sensitive adhesive layer which possess relatively strong adhesion to a surface prior to exposure to appropriate UV radiation, and relatively weak adhesion after exposure to appropriate UV radiation. That is, upon exposure to UV radiation, the tape becomes more readily releasable. Accordingly, a step of UV radiation exposure may be employed in the top film removal step when a film having a UV sensitive adhesive is employed.

The polymer layer of the present underfill structures is composed of a plurality of polymer regions. The polymer layer comprises at least 2 polymer regions, a first polymer region and a second polymer region, where the second polymer region comprises inorganic filler. It is preferred that the first polymer region is free of inorganic filler. Preferably, the polymer layer is composed of 2 polymer regions. It will be appreciated that more than 2 polymer regions may be used, although such additional polymer regions may add to the cost of the process. The polymer layer may be composed of a single polymer layer having at least 2 distinct regions, or alternatively, the polymer layer may be composed of a plurality of individual polymer layers, where such plurality of individual polymer layers forms at least 2 distinct regions. Each polymer region may be composed of a single polymer layer or may be composed of a plurality of individual polymer layers. It is preferred that the polymer layer is composed of 2 individual polymer layers, each individual polymer layer forming a distinct polymer region. It will be appreciated by those skilled in the art that a gradient of inorganic filler in the second polymer region may be achieved by using a plurality of individual polymer layers, where the layers have differing levels of inorganic filler.

The polymer layer may be comprised of any suitable polymer useful as an underfill. The first polymer region typically comprises one or more polymers, one or more crosslinkers, one or more thermal curing agents, and optionally one or more additives chosen from the group of fluxing agents, flow additives, flexibilizers, solvents, antifoam agents, impact modifiers, surfactants, adhesion promoters, and mixtures thereof. Any suitable polymers, crosslinkers, thermal curing agents and optionally additives may be used in the first polymer region. Any polymer useful as an underfill may suitably be used in the first polymer region. Preferably, the polymer is an epoxy, and more preferably a polymer of an epoxy and a di-functional amine monomer. It is further preferred that a di-functional epoxy monomer is used. A polymer formed from a tri-functional epoxy monomer may be used, provided the amount of the tri-functional epoxy is ≤ 5 wt% of the total weight of the monomers used to form the polymer, and preferably ≤ 3 wt%. Exemplary epoxies useful in forming the polymer include, but are not limited to: diglycidyl ether ofbisphenol A; diglycidyl ether of bisphenol F; diglycidyl ether of bisphenol S; diglycidyl ether of anthracene; diglycidyl ether of dicyclopentadiene; diglycidyl ether of naphthalene; diglycidyl ether of biphenyl; diglycidyl ether of propyleneglycol; and diglycidyl ether of dipropyleneglycol. Useful amines in forming the epoxy/amine polymers include, but are not limited to: 1,8-diaminomenthane; 2,6-diamino-2,6-dimethyl-5-phenylheptan-3-ol; 2,6-diamino-2,5,6-trimethylheptan-3-ol; trimethyleneglycol di-p-aminobenzoate; and oligomeric diamine polytetramethyleneoxide-di-p-aminobenzoate. Suitable crosslinkers are any aromatic material having two or more functional groups chosen from carboxylic acids, hydroxyls, and amines. Preferred crosslinkers include phenolic hardeners, such as novolac resins and diphenol biphenyls. Suitable novolac resins include, without limitation, phenol novolac, cresol novolac and resol novolac. Exemplary phenolic hardeners are those available under the trade names DL-92, MEH 7800-4S, MEH 7851SS and MEH 7500 from Meiwa Plastic Industries. Crosslinkers may be present in an amount of from 0 to 70 wt%, preferably from 5 to 50 wt%, and more preferably from 5 to 30 wt%. Suitable thermal curing agents include, without limitation, salts of nitrogen or phosphorus compounds. Preferred curing agents are: tetrabutylphosphonium hexafluorophosphate, tetraphenylphosphonium tetraphenylborate, tetrabutylphosphonium tetraphenylborate, tetraethylphosphonium hexafluorophosphate, tetrabutylphosphonium tetrafluoroborate; imidazole salts such as those available from Air Products under the CUREZOL™ brand; triaryl phosphines such as triphenyl phosphines; and tertiary amines such as benzyldimethyl amine and dicyandiamide. Thermal curing agents may be present in an amount of from 0 to 10 wt%, preferably from 0 to 5 wt% and more preferably from 0 to 3 wt%. Preferably, the first polymer region comprises a fluxing agent. Suitable fluxing agents are materials containing carboxylic acid, phenol or amine functional groups. A fluxing agent may be present in the first polymer region in an amount of from 0 to 50 wt%, preferably 0.01 to 20 wt%, and more preferably from 0.01 to 5 wt%. It is further preferred that the polymer forming the first polymer region also functions as a fluxing agent. Preferred polymers functioning as fluxing agents typically comprise a secondary amine moiety, where such polymer is present in the first polymer region in an amount of 0.1 to 70 wt%, more preferably from 30 to 70 wt%, and even more preferably 50 to 70 wt%.

The second polymer region typically comprises one or more polymers, one or more crosslinkers, one or more thermal curing agents, inorganic filler, and optionally one or more additives chosen from the group of fluxing agents, flow additives, flexibilizers, antifoam agents, impact modifiers, surfactants, adhesion promoters, solvents, and mixtures thereof. Any suitable polymers, crosslinkers, thermal curing agents, inorganic filler, and optionally additives may be used in the second polymer region. Any polymer useful as an underfill may suitably be used in the second polymer region. Preferably, the polymer is an epoxy, and more preferably a polymer of an epoxy and a difunctional amine monomer. It is further preferred that a di-functional epoxy monomer be used. A polymer formed from a tri-functional epoxy monomer may be used, provided the amount of the tri-functional epoxy in the polymer is ≤ 5 wt% of the total weight of monomers used, and preferably ≤ 3 wt%. Exemplary epoxies useful in forming the polymer include, but are not limited to: diglycidyl ether of bisphenol A; diglycidyl ether of bisphenol F; diglycidyl ether of bisphenol S; diglycidyl ether of anthracene; diglycidyl ether of dicyclopentadiene; diglycidyl ether of naphthalene; diglycidyl ether of biphenyl; diglycidyl ether of propyleneglycol; and diglycidyl ether of dipropyleneglycol. Useful amines in forming the epoxy/amine polymers include, but are not limited to: 1,8-diaminomenthane; 2,6-diamino-2,6-dimethyl-5-phenylheptan-3-ol; 2,6-diamino-2,5,6-trimethylheptan-3-ol; trimethyleneglycol di-p-aminobenzoate; and oligomeric diamine polytetramethyleneoxide-di-p-aminobenzoate. Suitable crosslinkers are any aromatic material having two or more functional groups chosen from carboxylic acids, hydroxyls, and amines. Preferred crosslinkers include phenolic hardeners, such as novolac resins and diphenol biphenyls. Suitable novolac resins include, without limitation, phenol novolac, cresol novolac and resol novolac. Exemplary phenolic hardeners are those available under the trade names DL-92, MEH 7800-4S, MEH 7851SS and MEH 7500 from Meiwa Plastic Industries. Suitable thermal curing agents include, without limitation, salts of nitrogen or phosphorus compounds. Preferred curing agents are tetrabutylphosphonium hexafluorophosphate, tetraphenylphosphonium tetraphenylborate, tetrabutylphosphonium tetraphenylborate, tetraethylphosphonium hexafluorophosphate, tetrabutylphosphonium tetrafluoroborate, and imidazole salts such as those available from Air Products under the CUREZOL™ brand. Thermal curing agents may be present in an amount of from 0 to 3 wt%, preferably from 0 to 2 wt% and more preferably from 0.01 to 1.5 wt%. The curing agent used in the second polymer region may be the same as or different from any curing agent used in the first polymer region. Any suitable solvent may be used in the second polymer region. Preferably, the second polymer region comprises a fluxing agent. Suitable fluxing agents are materials containing carboxylic acid, phenol or amine functional groups. A fluxing agent may be present in the second polymer region in an amount of from 0 to 20 wt%, preferably 0.01 to 15 wt%, and more preferably from 0.01 to 10 wt%. It is further preferred that the polymer forming the second polymer region also functions as a fluxing agent. Preferred polymers functioning as fluxing agents typically comprise a secondary amine moiety, where such polymer is present in the second polymer region in an amount of 0 to 50 wt%, more preferably from 30 to 50 wt%, and even more preferably 20 to 50 wt%. It is preferred that the polymer chosen for the first polymer region and the polymer chosen for the second polymer region are compatible, that is, that upon heating such as when the interconnect structures are electrically connected to bond pads, optionally in the presence of pressure, the two distinct polymer regions will form a unitary polymer region.

Inorganic filler is used to lower the overall coefficient of thermal expansion (CTE) of the polymer layer, and accordingly, of the underfill. The inorganic filler used in the present invention is non-conductive, and is inert, that is, it will not react with or destabilize the polymer layer. An amount of inorganic filler is used in the polymer layer in order to get the CTE of the underfill close to the relatively lower CTE of the component (e.g., silicon in the case of a silicon wafer) for silicon to silicon bonding, or between the relatively lower CTE of the component (e.g., silicon) and the relatively higher CTE of an organic substrate (such as a circuit board, e.g., FR4). The proper choice of CTE is necessary for stress mitigation during manufacturing and subsequent use of the electronic assembly. The first polymer region may optionally comprise inorganic filler. When filler is present in the first polymer region, the amount of such filler is less than the amount of the inorganic filler in the second polymer region. If used, the amount of inorganic filler in the first polymer region is ≤ 40 wt%, based on the total weight of the material in the first polymer region, preferably ≤ 30 wt%, and more preferably ≤ 20 wt%. It is preferred that the first polymer region is free of inorganic filler. The second polymer region comprises ≥ 40 wt% of inorganic filler, preferably ≥ 50 wt%, and more preferably ≥ 60 wt%. Preferably, the inorganic filler is silica, a metal oxide or a ceramic. Suitable ceramic inorganic fillers are crystalline oxides, nitrides or carbides. It is preferred that the inorganic filler is chosen from silica, alumina, zirconia, berylia, ceria, zinc oxide, silicon nitride, aluminum nitride, boron nitride, and silicon carbide, and more preferably silica, alumina, zirconia, silicon nitride, aluminum nitride, boron nitride, and silicon carbide. Mixtures of inorganic filler may be used. The inorganic filler may have any suitable shape and size. Preferably, the inorganic filler has a spherical or substantially spherical shape. Such spherical shape minimizes surface area and allows for a higher loading of filler in the polymer region. It is preferred that the inorganic filler has a size, such as a particle size, that will not impede the penetration of the second polymer region by interconnect structures. It is preferred that the inorganic filler has a mean particle size of 0.005 to 10 µm, more preferably from 0.01 to 5 µm, and yet more preferably 0.01 to 3 µm The inorganic filler may optionally be treated with an adhesion promoter to modify the surface chemistry of the filler particle, for example, to allow the inorganic filler particle to react with the polymer or crosslinker used in the polymer region. Modifying the surface chemistry of the filler may improve fracture toughness and may improve the dispersion of the filler in the polymer region.

In general, each of the first polymer region and second polymer region may have any suitable thickness. Preferably, the thickness of the second polymer region is greater than the thickness of the first polymer region, and more preferably, the thickness of the second polymer region is much greater than the thickness of the first polymer region. Typically, the first polymer region has a thickness in the range of 0.1 to 10 µm, and more preferably from 0.1 to 5 µm. Typically, the second polymer region has a thickness of 5 to 150 µm, and more typically from 10 to 100 µm, although a wide variety of thicknesses may be used in the present underfill structures.

Since both the top and bottom film layers are removed from the present underfill structure before an electronic assembly is formed, the only critical dimension in the underfill structure is the thickness of the polymer layer. As the height of interconnect structures vary considerably depending upon the particular structures used, there is no specific range of thicknesses for the polymer layer in the structures of the present invention. The total thickness of the polymer layer, that is, the combined thicknesses of the first and second polymer regions, may be greater than, equal to, or less than the height of the interconnect structures used to form the electronic assembly. The height of the second polymer region is critical and is equal to or less than the height of the interconnect structures, and preferably is less than the height of the interconnect structures. The first polymer region, which may also function as a fluxing agent, may cover the top of the interconnect structures. If the height of the polymer layer is much greater than the height of the interconnect structures, there is a risk that the polymer layer will bleed out along the substrate or creep up the sidewall of the die. There is also the potential that it will prevent good contact between the interconnect structures and the conductive pads to which they are to be electrically connected. If the height of the polymer layer is too much less than the height of the interconnect structures, then following assembly of a component to a substrate, an undesirable gap may remain between the polymer layer and the substrate or the component. The difference in height between the top of the interconnect structures and the top surface of the polymer layer should be sufficient to account for spreading of the interconnect structures and of the underfill during assembly of the electronic device, as a component and substrate are brought into contact and heated to solder the component to the substrate, that is, electrically connect the interconnect structure to the conductive bond pads. After such assembly, the polymer layer should fill the space between the surface of the component and the surface of the substrate.

The bottom film layer in the present underfill structure typically functions as a support for the polymer layer and any other layers of the dry film underfill structure during manufacture, storage and subsequent processing. In general, the bottom film layer is removed from the dry film (polymer layer), such as by peeling, and is typically removed before the present underfill structure is laminated to a surface. Accordingly, adhesion between the bottom film layer and the polymer layer is typically low to moderate to allow for ease in separation. In general, the bottom film layer is removed before the top film layer, so the adhesion between the bottom film layer and the polymer layer is relatively lower than the adhesion between the top film layer and the polymer layer. The particular material used for the bottom film layer can vary widely and the particular material used is not critical. The material for the bottom film layer may be rigid or flexible, and is typically in roll or sheet form. Suitable bottom film layer materials include, without limitation: polyester such as polyethylene terephthalate (PET); paper; nylon; glass; cellulose acetate; polyolefin; polyimide; polyurethane; poly(meth)acrylate; metal sheet; epoxy laminate; copper coated fiberboard; and the like. Materials, such as PET, paper and the like, may be coated in various ways. For example, PET may be resin-coated, flame or electrostatic discharge treated, or slip treated. Paper used as a bottom film is typically resin-coated, such as polyethylene-coated paper or polyvinyl alcohol coated paper. Preferably, the bottom film layer is a polyolefin, and more preferably polyethylene. While the bottom film layer typically has a thickness of from 5 to 250 µm, the exact thickness of the bottom film layer is not critical as long as it can support the other layers of the underfill structure.

Optionally, a release layer may be disposed between the bottom film layer and the polymer layer. A release layer is typically used when the adhesion between the bottom film layer and the polymer layer is relatively too high, such that the bottom film layer is not easily removable from the polymer layer without damage to the polymer layer or other layers of the underfill structure. Any release layer used needs to render the bottom film layer peelable from the polymer layer. When a release layer is used, it is preferred that the release layer remains with the bottom film layer when the bottom film layer is removed from the underfill structure and that no release layer residue is left on the polymer layer. It is preferred that a release layer is not used.

Underfill structures of the present invention may be formed by providing a bottom film, such as a PET film, and coating a layer of an inorganic filler-containing polymeric material (filled material) on the top surface of the film. The inorganic filler-containing polymer layer may be coated using a slot die, knife over roll, or by another suitable coating method known to those skilled in the art, and is then typically dried before further processing. Additional filler-containing polymeric layers may be deposited if needed to achieve a desired thickness of inorganic-filler containing region. Next, a layer of polymeric material containing a reduced amount of inorganic filler as compared to the filled material layer, and preferably no inorganic filler (unfilled material layer), is coated onto the filled material layer by gravure coating or other suitable method known to those skilled in the art, and is then typically dried before further processing. Alternatively, a layer of unfilled polymeric material may be disposed on the top of the filled polymeric material layer by lamination. More than one unfilled polymer layer may be used to achieve a desired thickness of the unfilled polymer region. The top film layer is then laminated onto the surface of the unfilled polymer layer using pressure, optionally with heating. When a buffer layer is used in the present underfill structures, it is preferred that the buffer layer be first coated onto the top film layer by any suitable method used in the art, and then the top film layer containing the buffer layer is laminated to the unfilled polymer layer using pressure, and optionally heat.

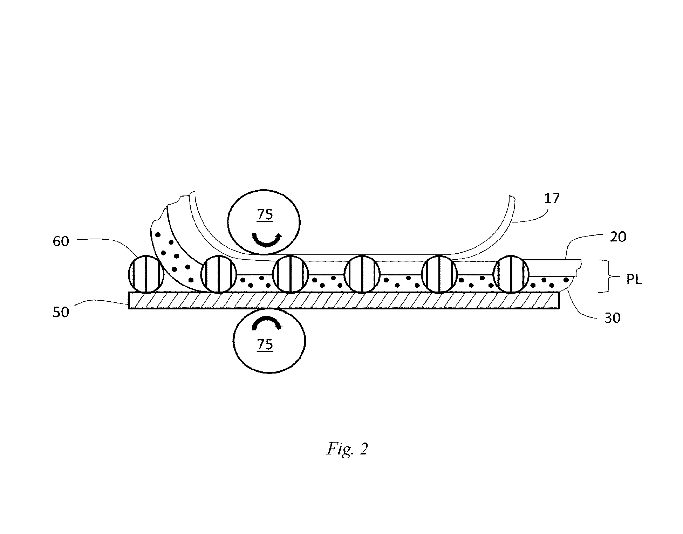

A wide variety of dry film lamination techniques are known in the art and any of these techniques are suitable for laminating the present underfill structure to a surface, such as hot roll lamination, vacuum lamination, wet lamination, and combinations of the foregoing, among others. Vacuum lamination is preferred. Fig. 2 illustrates a hot roll lamination technique using the underfill structure of Fig. 1A. First, bottom film layer **40** is removed from the underfill structure using any suitable method (step not shown), next the underfill structure is laminated to a surface of component **50** having solder bumps (interconnect structures) **60** disposed on its surface, with pressure applied from a pair of oppositely disposed hot rollers **75**, one roller being disposed below the component and applying pressure to a back surface of the component and the other roller being disposed above the underfill structure and applying pressure to top film portion **17**. The arrows in rollers **75** indicate the direction of roller rotation. The pressure from rollers **75** pushes polymer layer **PL** between solder bumps **60**. Polymer layer **PL** is composed of first polymer region **20** and second polymer region **30**, where the second polymer region comprises inorganic filler. The overall height of the polymer layer **PL** may be less than (shown), equal to (not shown), or greater than (not shown) the height of solder bumps **60**. After exiting rollers **75**, top film portion **17** (comprising a top film layer and optional buffer layer) is removed from the structure using any suitable method resulting in a pre-applied underfill (polymer layer **PL**) disposed between solder bumps **60** on the surface of component **50.**

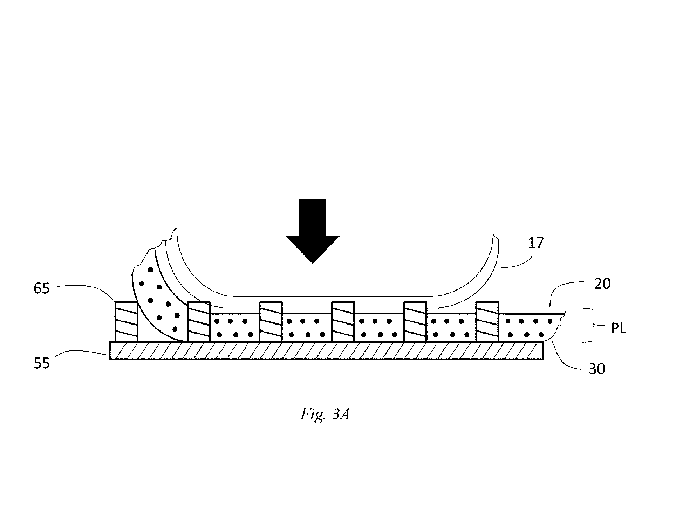

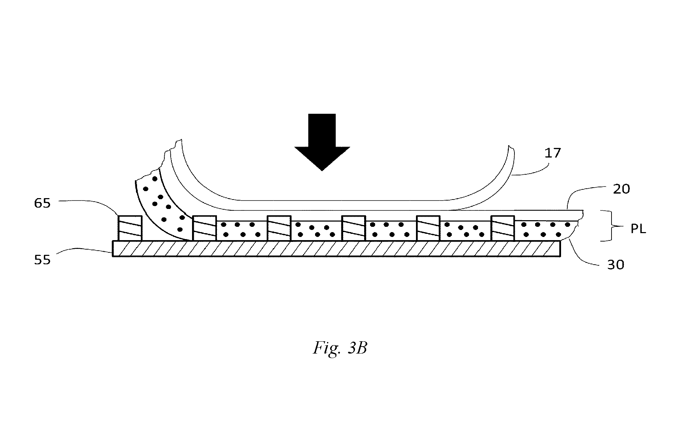

Fig. 3A illustrates a vacuum lamination technique using the underfill structure of Fig. 1A. First, bottom film layer **40** is removed from the underfill structure using any suitable method (step not shown), next the underfill structure is laminated to a surface of component **55** having metal pillars (interconnect structures) **65** disposed on its surface. A silicone rubber diaphragm in the vacuum lamination machine (not shown) can be used to press and adhere the underfill structure onto the surface of component **55** using heat and pressure. The vacuum inside the vacuum chamber can be used to pull down the diaphragm onto the component surface and pressure can also be applied behind the diaphragm (indicated by the arrow in Fig. 3A). Any pressure applied behind the diaphragm works in conjunction with the vacuum pull-down to push polymer layer **PL** between metal pillars **65**. Polymer layer **PL** is composed of first polymer region **20** and second polymer region **30**, where the second polymer region comprises inorganic filler. The overall height of polymer layer **PL** (first polymer region **20** + second polymer region **30**) may be less than (shown), equal to (not shown), or greater than (not shown) the height of metal pillars **65**, while the height of second polymer region **30** is less than the height of metal pillars **65.** After the atmosphere is introduced into the vacuum chamber, top film portion **17** (comprising a top film layer and an optional adhesive layer) is removed from the structure using any suitable method resulting in a pre-applied underfill (polymer layer **PL**) disposed between metal pillars **65** on the surface of component **55**. Fig. 3B illustrates a process similar to that shown in Fig. 3A, except that the height of polymer layer **PL** is greater than the height of metal pillars **65**, while the height of second polymer region **30** is less than the height of metal pillars **65**. In Fig. 3B, first polymer region **20** covers the tops of metal pillars **65**.

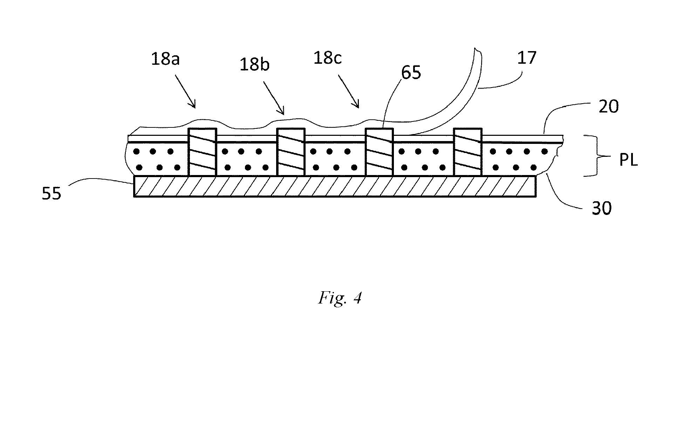

As discussed above in reference to Figs. 2 and 3, the total height (h) of the polymer layer is less than, equal to, or greater than the height of the interconnect structures on the surface to which the underfill structure is laminated, while the height of the second polymer region is less than or equal to the height of the interconnect structures, and preferably is less than the height of the interconnect structures. Fig. 4 illustrates an expanded view of a preferred laminated structure of Fig. 3A, where like reference numerals refer to like elements. Top film portion **17** is composed of an elastomeric top film layer and a buffer layer (PSA). In Fig. 4, the total height h of the polymer layer **PL** and top film portion **17** is less than the height of metal pillars **65**. The total height h is sufficiently close to the height of metal pillars **65** such that the top film portion **17** is deformed by the metal pillars without being pierced by them. Such deformations in the top film layer, referred to as Calvert nubbins, are shown by **18a, 18b,** and **18c.** Metal pillars **65** are not deformed by the lamination method or by top film portion 17. While not wishing to be bound by theory, it is believed that the pliability of top film portion 17, and in particular the pliability of the buffer layer of top film portion 17, allows for such lamination without substantially deforming the interconnect structures. It will be appreciated by those skilled in the art that when the height of the first polymer region is such that it covers the tops of interconnect structures, the height of Calvert nubbins may be reduced or their presence even eliminated.

Underfill structures of the present invention may be laminated to a variety of substrates. Typically, underfill structures of Fig. 1A are laminated to a component (active device) having interconnect structures, such that the second polymer region comprising the inorganic filler is adjacent to the component surface. Suitable components include, without limitation, integrated circuits, among others. The present underfill structures may be used on a wide variety of interconnect structures, such as solder bumps, metal pillars, and the like. Interconnect structures may be composed of solder, as in the case of solder bumps, or of a non-solder material with a solderable cap. Exemplary solders used to form solder bumps include, but are not limited to, tin, tin-lead, tin-silver, tin-bismuth, tin-copper, tin-silver-copper, and the like. Exemplary metal pillars are copper pillars. Metal pillars have a solderable cap portion, where such solderable cap may be any suitable solder. Metal pillars may also include one or more metal layers, such as a nickel layer, disposed between the metal and the solderable cap layer. Such interconnect structures have a wide variety of sizes, depending upon the design of the component. Suitable substrates include printed circuit boards (PCBs), package substrates, and the like. For example, a flip chip may be mounted on a package substrate and the resulting package mounted on a PCB, or alternatively, a flip chip may be directly mounted to a PCB.

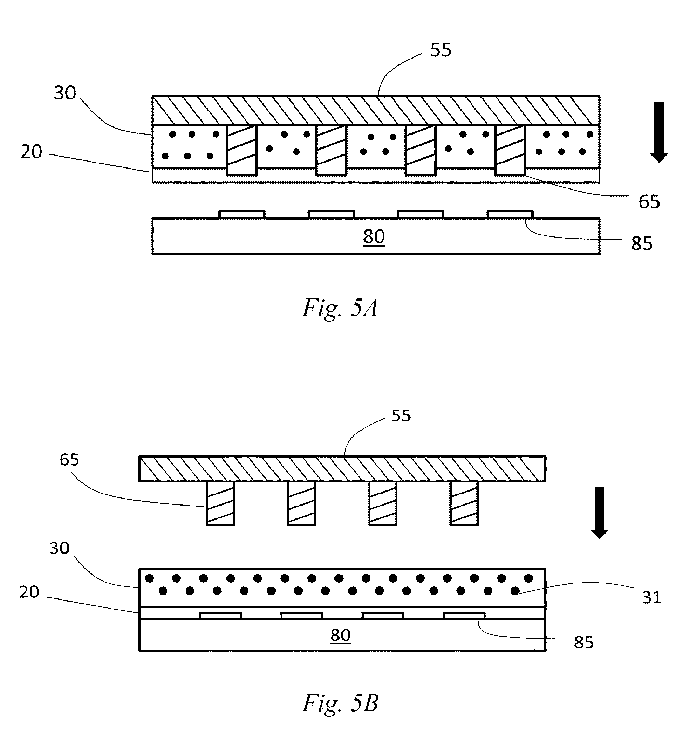

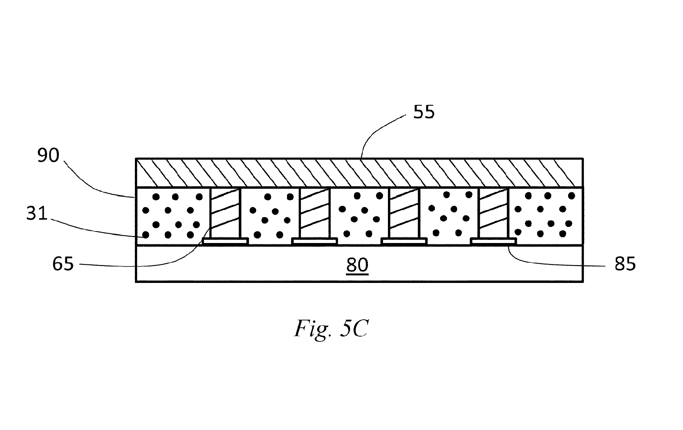

After the underfill structure is laminated to a surface, the top film layer is removed, along with any optional buffer layer. In one embodiment, the underfill structure is laminated to a component having interconnect structures, such as that shown in Fig. 4. Following removal of the top film layer, **17**, an upper portion of the interconnect structures (metal pillars) **65** is exposed above the surface of polymer layer **PL** as is shown in Fig. 4, to provide a pre-applied underfill on component **55**. Next, the component is mounted to a substrate. Fig. 5A shows an alternate embodiment of the component from Fig. 4 having pre-applied underfill where the second polymer region **30** has a height less than the height of metal pillars **65** and where first polymer region **20** covers the tops of the metal pillars, and where the component is flipped over and ready for mounting to conductive pads **85** on the surface of substrate **80**. The top portion of interconnect structures **65** is registered with conductive bond pads **85** and the interconnect structures **65** are brought into contact with the conductive bond pads **85**, as indicated by the arrow in Fig. 5A, to form a unit.

Fig. 5B illustrates an alternate method of forming an electrical assembly. In Fig. 5B, the underfill structure from Fig. 1B has been laminated to substrate **80**, such as a circuit board substrate, over conductive bond pads **85** on the surface of the substrate. After removal of the top film, the top surfaces of interconnect structures **65** on the surface of component **55** are registered to conductive bond pads **85** and are brought into contact, as shown by the arrow in Fig. 5B, to form a unit.

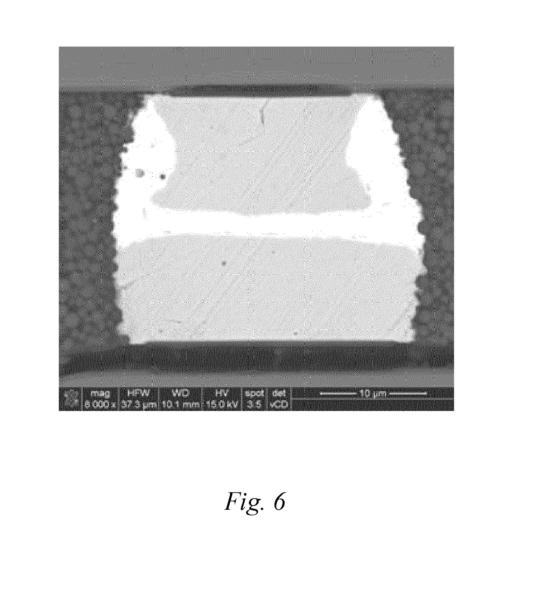

In both Figs. 5A and 5B, the second region **30** of the polymer layer is adjacent to the component (active device), while the first region **20**, having a reduced level of inorganic filler, and preferably no inorganic filler, is adjacent to substrate **55** having the conductive bond pads. After the interconnect structures of the component are brought into contact with the conductive bond pads on the mounting substrate to form a unit, the unit is subjected to conditions to electrically connect the interconnect structures with the bond pads. Such conditions include, but are not limited to, thermosonic bonding and heating the unit, typically with pressure being applied to either the component, the substrate or both, to at least partially melt the interconnect structures and electrically connect (solder) the interconnect structures to the conductive bond pads. During this heating step, the pre-applied underfill (polymer layer) further cures (polymerizes). An advantage of using a relatively thin first polymer region in the present dry film structures is that after the soldering (or thermosonic bonding) step a unitary (or single) bulk region is formed, that is, the first and second polymer regions form a unitary bulk region. While not wishing to be bound by theory, it is believed that such a unitary bulk region has a substantially uniform concentration of inorganic filler throughout the bulk. That is, the unitary bulk region is substantially free of an inorganic filler concentration gradient, and is preferably free of such a concentration gradient. The formation of a unitary bulk structure is aided, at least in part, by selecting polymers for the first and second polymer regions that are compatible with each other. Fig. 6 is a cross-sectional micrograph of an underfill structure of the invention showing an interconnect structure soldered to a bond pad surrounded by a unitary bulk underfill material having a substantially uniform concentration of inorganic filler. That is, no unfilled polymer region is detectable in Fig. 6.

The fluxing performance of underfills, which is critical for proper bonding of a component to a substrate, can be diminished because of high levels of inorganic filler. The formulation components that are responsible for fluxing are reduced in concentration due to the presence of high levels of inorganic filler. Also, significant filler entrapment can occur in the electrically conductive joints that are formed during the bonding process because of the high concentration of inorganic filler. This entrapped filler can severely degrade electrical performance because the inorganic fillers are non-conductive. Conductive fillers would cause undesirable shorting to occur. The present underfill structures address the issues of improved fluxing and reduced, and preferably no, filler entrapment that are encountered with conventional underfill approaches.

Example 1 - Preparation of Unfilled Polymer Material. To a jacketed 3 L reactor fitted with an over head stirrer, thermometer and condenser was added 2000.0 g (11.3 mol) of diglycidyl ether of bisphenol A (DER 332 from The Dow Chemical Company, EEW: 177) and 545.7 g propylene glycol monomethyl ether (PGME). The solution was heated to 50° C and allowed to stir for 10 min. to ensure thorough mixing. After adequate agitation, a 182.8 g (4.3 mol) portion of 1,8-menthane diamine (Primine MD from The Dow Chemical Company) was added with stirring and the resulting mixture was heated to 100° C. Once stabilized at 100° C, the mixture was stirred for 1 hour, after which the heat was further increased to 130° C and the material allowed to stir for an additional 4 hours. After the reaction was completed, the temperature was lowered and the b-staged polymer was dropped into a 4 L glass bottle for storage.

Subsequent to polymerization, 15.98 g of the diglycidyl ether of Bisphenol A/ Primene MD/PGME b-staged polymer adduct was combined with 12.23 g of phenolic hardener (MEH 7851SS (OH equivalent weight: 210) from Meiwa Plastic Industries), 3.32 g of additional PGME and 6.24 g of n-butyl acetate. The mixture was spun in a double planetary mixer at 2000 rpm for 5 min. to thoroughly combine the ingredients. To this mixture was added 0.17g of flow additive (Tegoflow 370), 0.75 g of toughening agent (BTA 753ER), 11.25 g of flexibilizer with epoxy functionalities (EXA 4850-150, EEW: 440). The resulting material was again spun in a double planetary mixer at 2000 rpm for 5 min. Finally, 0.07 g of catalyst (tetrabutyl phosphonium hexafluoro phosphate) was added. The resulting material was again spun in a double planetary mixer at 2000 rpm for 2 min. Additionally, to ensure complete dispersion of the all components in the polymer matrix; the resulting material could be passed twice through a three roll mill, producing a free flowing, viscous liquid.

Example 2 - Preparation of Unfilled Polymer Material. In a glass vial, 0.28g of a fluxing agent (1,4-dihydroxy 2-carboxy naphthoic acid from Sugai Chemicals Industries) was added along with 10 g of a suitable solvent (e.g. 1,3-dioxalane). The glass vial was shaken until the fluxing agent dissolved in the solvent. This solution was then transferred to a container used for mixing in a high speed mixer. 2.50g of diglycidyl ether of bisphenol A (DER 332 from The Dow Chemical Company, EEW: 177) and 3.28g EHGE-Primene MD adduct was added to the container. To make the EHGE-Primene MD adduct, 124.0 parts (0.66 mole) of ethylhexyl glycidyl ether (EHGE) [from Hexion Specialty Chemicals] was added to 56.7 parts (0.33 mole) of 1,8-menthane diamine (PMD, from Dow Chemical Company) under nitrogen and with agitation at ambient temperature. The mixture was heated to 75° C for 2 hours, followed by 2 hours at 140° C. Then, the final mixture was kept at 80° C under vacuum (30 mm Hg) for another 2 hours to remove any volatiles to afford the product PMD/EHGE adduct as shown in the following Equation.

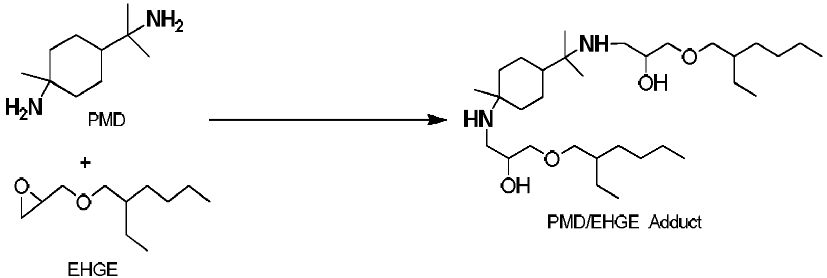

The container with the mixture of 1,4-dihydroxy 2-carboxy naphthoic acid, 1,3-dioxalane, DER 332 and EHGE-Primene MD adduct was then loaded in a high speed mixer and mixed for 3 min. at 2000 rpm. The mixture was then placed in a glass pan and into an oven set at 100° C for 30 min. to 1 hour to remove the solvent. The glass pan was then removed from the oven and the mixture was collected in a glass bottle.

Example 3 - Preparation of Unfilled Polymer Material. In a glass vial, 0.76g of a fluxing agent (1,4-dihydroxy 2-carboxy naphthoic acid from Sugai Chemicals Industries) was added along with 10 g of a suitable solvent (e.g. 1,3-dioxalane). The glass vial was shaken until the fluxing agent dissolved in the solvent. This solution was then transferred to a container used for mixing in a high speed mixer. 8.0g of diglycidyl ether of bisphenol A (DER 332, from The Dow Chemical Company, EEW: 177) and 6.35g of allyl phenol novolac resin (MEH 8000H from Meiwa Plastic Industries) was added to the container. The container was then loaded in a high speed mixer and mixed for 3 min. at 2000 rpm. The mixture was then placed in a glass pan and into an oven set at 100° C for 30 min. to 1 hour to remove the solvent. The glass pan was then removed from the oven and the mixture was collected in a glass bottle.

Example 4 - Preparation of Unfilled Polymer Material. Various unfilled polymer materials are prepared by repeating the procedure of Example 1 except that the bisphenol A is replaced with a molar equivalent of a difunctional epoxy monomer listed in Table 1.

**Table 1**

| Sample | Epoxy |
|---|---|
| 4A | Diglycidyl ether of bisphenol F |
| 4B | Diglycidyl ether of naphthalene |
| 4C | Diglycidyl ether of bisphenol S |
| 4D | Diglycidyl ether of anthracene |
| 4E | Diglycidyl ether of dicyclopentadiene |

Example 5 - Preparation of Unfilled Polymer Material. Various unfilled polymer materials are prepared by repeating the procedure of Example 1 except that the epoxy monomers, amine crosslinkers and phenolic hardeners (from Meiwa Plastic Industries) reported in Table 2 are used.

**Table 2**

| Sample | Epoxy | Amine Crosslinker | Phenolic Hardener |
|---|---|---|---|
| 5A | Diglycidyl ether of bisphenol F | EHGE-Primene MD adduct | DL-92 |
| 5B | Diglycidyl ether of naphthalene | 2,6-Diamino-2,5,6-trimethylheptan-3-ol | MEH-7851SS |
| 5C | Diglycidyl ether of bisphenol S | Trimethyleneglycol di-p-aminobenzoate | MEH-7500 |
| 5D | Diglycidyl ether of anthracene | 2,6-Diamino-2,6-dimethyl-5-phenylheptan-3-ol | MEH-7500 |
| 5E | Diglycidyl ether of dicyclopentadiene | Polytetramethyleneoxide-dip-aminobenzoate | DL-92 |
| 5F | Diglycidyl ether of bisphenol A | Trimethyleneglycol di-p-aminobenzoate | MEH-7800 4S |
| 5G | Diglycidyl ether of bisphenol A | 2,6-Diamino-2,5,6-trimethylheptan-3-ol | MEH-7500 |

Example 6 - Preparation of Filled Polymer Material. To a jacketed 3 L reactor fitted with an over head stirrer, thermometer and condenser was added 2000.0 g (11.3 mol) of diglycidyl ether of bisphenol A (DER 332 from The Dow Chemical Company, EEW: 177) and 537.6 g PGME This material was heated to 50° C and allowed to stir for 10 min. to ensure thorough mixing. After adequate agitation, a 145.2 g (3.4 mol) portion of 1,8-menthane diamine (Primine MD from The Dow Chemical Company) was added with stirring and the resulting mixture was heated to 100° C. Once stabilized at 100° C, the mixture was stirred for 1 hour, after which the heat was further increased to 130° C and the material allowed to stir for an additional 4 hours. After the reaction was completed, the temperature was lowered and the b-staged polymer was dropped into a 4 L glass bottle for storage.

Subsequent to polymerization, 7.72 g of the diglycidyl ether of Bisphenol A/ Primene MD/PGME b-staged polymer adduct was combined with 5.95 g of phenolic hardener (MEH 7851SS (OH equivalent weight: 210) from Meiwa Plastic Industries), 5.92 g of additional PGME and 7.46 g of n-butyl acetate. This mixture was spun in a double planetary mixer at 2000 rpm for 5 min. to thoroughly combine the ingredients. To this mixture was added 0.22 g of flow additive (Tegoflow 370), 0.92 g of toughening agent (BTA 753ER), 4.32 g of flexibilizer with epoxy functionalities (EXA 4850-150, EEW: 440) and 0.13 g of glycidoxytrimethoxysilane. The resulting material was again spun in a double planetary mixer at 2000 rpm for 5 min. To this mixture was added 27.27 g of fused silica and the resulting mixture was spun in a double planetary mixer at 2000 rpm for 10 min. The amount of silica was 60 wt% on a solids basis after removal of solvent. Finally, 0.09 g of catalyst (tetrabutylphosphonium hexafluorophosphate) was added. The resulting material was again spun in a double planetary mixer at 2000 rpm for 2 min. To ensure complete dispersion of the silica in the polymer matrix, the resulting material was passed twice through a three roll mill, producing a free flowing, viscous liquid largely free of particle agglomerates.

Example 7 - Preparation of Filled Polymer. Various filled polymer materials are prepared by repeating the procedure of Example 6 except that the epoxy monomers, amine crosslinkers and phenolic hardeners (from Meiwa Plastic Industries) reported in Table 3 are used.

**Table 3**

| Sample | Epoxy | Amine Crosslinker | Phenolic Hardener |
|---|---|---|---|
| 7A | Diglycidyl ether of naphthalene | EHGE-Primene MD adduct | DL-92 |
| 7B | Diglycidyl ether of bisphenol A | 2,6-Diamino-2,5,6-trimethylheptan-3-ol | MEH-7500 |
| 7C | Diglycidyl ether of bisphenol S | 2,6-Diamino-2,6-dimethyl-5-phenylheptan-3-ol | DL-92 |
| 7D | Diglycidyl ether of bisphenol F | Trimethyleneglycol di-p-aminobenzoate | MEH-7851SS |
| 7E | Diglycidyl ether of bisphenol A | Trimethyleneglycol di-p-aminobenzoate | MEH-7851SS |

Example 8 - Preparation of Filled Polymer Material. Various filled polymer materials are prepared by repeating the procedure of Examples 6 and 7 except that the following fillers were used in the amounts reported in Table 4 are used.

**Table 4**

| Sample | Filled Polymer Material | Filler | Filler Amount (wt%) |
|---|---|---|---|
| 8A | Example 6 | Fused Silica | 70 |
| 8B | Example 6 | Fused Silica | 45 |
| 8C | Example 6 | Fused Silica | 40 |
| 8D | Example 7A | Alumina | 55 |
| 8E | Example 6 | Alumina | 60 |
| 8F | Example 7C | Fused Silica | 50 |
| 8G | Example 7D | Zirconia | 65 |
| 8F | Example 7D | Zirconia | 60 |
| 8H | Example 6 | Boron Nitride | 70 |

Example 9 - Preparation of Underfill Structure. Filled polymer material from Example 6 was coated using a slot die on a PET carrier film (bottom film). This coating was passed through a multi-stage oven with peak temperature of 110° C to drive off the solvent resulting in a dry film. Unfilled polymer material from Example 1 was then applied onto the filled polymer material using a drawdown bar selected to achieve a desired film thickness. This assembly was then placed in a convention oven and exposed to a multistep drying process with a peak temperature of 110° C to drive the off solvent in the unfilled polymer material. This assembly was then laminated to a backgrinding tape (top film layer) having a PSA layer using a hot roll laminator with the unfilled polymer layer adhering to the adhesive layer on the backgrind tape. The PET carrier film (bottom film) was peeled off and the exposed surface of the filled polymer material was then laminated onto a wafer using a vacuum laminator.

Example 10 - Preparation of Underfill Structure. The procedure of Example 9 is repeated except that the unfilled polymer of Example 2 is used.

Example 11 - Preparation of Underfill Structure. The procedure of Example 9 is repeated except that the unfilled polymer of Example 3 is used.

## Claims

1. An underfill structure comprising in order: a top film layer; a polymer layer, and a bottom film layer, wherein the polymer layer comprises a first polymer region and a second polymer region, wherein the second polymer region comprises inorganic filler.

2. The underfill structure of claim 1 wherein the second polymer region further comprises a layer comprising a curable polymer, crosslinking agent, and curing agent.

3. The underfill structure of claim 1 or claim 2 wherein the inorganic filler is present in the second polymer region in an amount of ≥ 40 wt%, based on the total weight of the second polymer region.

4. The underfill structure of any of claims 1 to 3 wherein an adhesive layer is disposed between the top film layer and the polymer layer.

5. The underfill structure of any preceding claim wherein the top film layer is composed of an elastomer.

6. The underfill structure of any preceding claim wherein the top film layer is a polymer chosen from polyolefins, polyesters, polyurethanes, poly(vinyl chloride), poly(vinylidene chloride), ethylene vinyl acetate, and poly(meth)acrylates.

7. The underfill structure of any preceding claim wherein the bottom film layer is chosen from polyester, polyamide, polyimide, polyolefin, polyacrylate, polyurethane, and metal.

8. The underfill structure of any preceding claim wherein the first polymer region comprises a curable polymer, crosslinking agent, and curing agent.

9. The underfill structure of claim 8 wherein the first polymer region further comprises inorganic filler in an amount that is less than the amount of inorganic filler in the second polymer region.

10. The underfill structure of claim 8 wherein the first polymer region is free of inorganic filler.

11. A method comprising:
providing the underfill structure of any preceding claim;
removing the bottom film from the underfill structure;
laminating the underfill structure to a surface of a component having interconnect structures thereon, such that the underfill structure is forced between interconnect structures, wherein the height of the second polymer region is less than or equal to the height of the interconnect structures; and
removing the top film layer.

12. The method of claim 11 further comprising: registering a top portion of the interconnect structures with conductive bond pads on a surface of a substrate to form a unit; and causing the interconnect structures to electrically connect the interconnect structures to the conductive bond pads.

13. A method comprising: providing the underfill structureof any of claims 1 to 10; removing the bottom film from the underfill structure; laminating the underfill structure to a surface of a substrate having conductive bond pads such that the first polymer region is directly on the surface of the substrate; and removing the top film layer.

14. The method of claim 13 further comprising: registering the conductive bond pads with interconnect structures on a surface of a component to form a unit; and heating the unit to melt the interconnect structures to electrically connect the interconnect structures with the conductive bond pads.
